# FASCICULE DE BREVET EUROPEEN

(11) **EP 1 175 333 B1**
(45) Date de publication et mention de la délivrance du brevet: **25.05.2005**
(21) Numéro de dépôt: 00922775.2
(22) Date de dépôt: 27.04.2000
(51) Int. Cl.: B64C 1/14, H05K 9/00

(54) **VITRAGE MULTIPLE ISOLANT, EN PARTICULIER HUBLOT D'AVION, A BLINDAGE ELECTROMAGNETIQUE**
MEHRSCHEIBENISOLIERGLAS, INSBESONDERE FLUGZEUGFENSTER MIT ELEKTROMAGNETISCHER ABSCHIRMUNG
MULTIPLE GLAZED INSULATING UNIT, ESPECIALLY FOR AN AIRCRAFT WINDOW, WITH ELECTROMAGNETIC ARMOUR

(30) Priorité: 28.04.1999 FR 9905374
(43) Date de publication de la demande: 30.01.2002
(73) Titulaire: SAINT-GOBAIN GLASS FRANCE, 92400 Courbevoie (FR)
(72) Inventeur: CHAUSSADE, Pierre, F-45100 Orléans (FR); DROUET, Xavier, F-95470 Fosses (FR)
(74) Mandataire: Muller, René
(86) Numéro de dépôt international: PCT/FR2000/001133
(87) Numéro de publication internationale: WO 2000/066426

(56) Documents cités:
- EP-A- 0 277 818
- EP-A- 0 291 591
- EP-A- 0 299 607
- EP-A- 0 413 580
- US-A- 5 670 742

## Description

La présente invention concerne les vitrages multiples isolants à au moins une lame de gaz, en particulier d'air, notamment les hublots d'engins de transport, et plus particulièrement les hublots d'avions.

Le fuselage d'un avion constitue une enveloppe métallique qui assure une fonction de blindage électromagnétique. De la même façon, le pare-brise d'un avion est métallisé par exemple par l'incorporation d'une couche conductrice et transparente utilisée pour le dégivrage. On isole de cette manière les équipements de l'avion susceptibles d'être perturbés par un champ électromagnétique.

Toutefois, le blindage électromagnétique du fuselage comporte des "trous électromagnétiques" que constituent les hublots. En effet, les hublots, formés d'une manière générale de double vitrages de poly(méthacrylate de méthyle) avec interposition d'une lame d'air, n'assurent pas de fonction de blindage électromagnétique.

Or, avec l'apparition des téléphones portables et des ordinateurs portables que les passagers utilisent pendant leurs voyages en avion, le besoin se fait sentir d'assurer la continuité du blindage électromagnétique de l'avion. En effet, ces appareils portables peuvent provoquer de perturbations, gênant les liaisons entre les personnels de navigation et la tour de contrôle. Il devient donc maintenant impératif, pour des raisons de sécurité, d'isoler parfaitement l'intérieur des avions en disposant d'un blindage électromagnétique continu.

Des solutions ont été proposées par les demandes de brevet EP-A-0 299 607 et EP-A-0 413 580, lesquelles décrivent des vitrages dont la partie vitrée comporte au moins une couche mince électroconductrice et transparente reliée électriquement à la terre par des moyens de connexion électrique supplémentaires, tels que des mailles métalliques ou des joints électroconducteurs. Ces moyens apportent toutefois une complexité dans la fabrication et/ou la mise en place du vitrage.

La présente invention obvie aux inconvénients cités. La présente invention a donc d'abord pour objet un vitrage multiple isolant selon la revendication 1.

D'une manière générale, les dalles de substrat transparent, mécaniquement résistant, sont constituées par des plaques de verre monolithique (verre sodocalcique), ou par des plaques de polymère, tel que le poly(méthacrylate de méthyle) (PMMA), ou par des plaques de verre feuilleté, du type de celles dans lesquelles une feuille de polyvinylbutyral (PVB) ou de polyuréthanne (PU), d'une épaisseur généralement comprise entre 0,3 et 2 mm, est prise en sandwich entre deux feuilles de PMMA. De façon traditionnelle, ces plaques peuvent être planes ou bombées ou cintrées. Les vitrages particulièrement préférés car Les plus courants sont les double vitrages.

De préférence, on prévoit que la ou les couches minces électroconductrices transparentes, appliquées conformément à la présente invention, sont disposées à l'intérieur d'un vitrage multiple, de telle sorte que ces couches se trouveront protégées des agressions mécaniques et des rayures. Cependant, le dépôt de la couche électroconductrice peut quand même se faire sur une face extérieure du vitrage, en particulier du côté intérieur à l'avion, où un "survitrage" encore appelé "hublot décor" est généralement présent et permet quand même une certaine protection de la couche.

Conformément à un premier mode de réalisation de la présente invention, au moins une couche mince transparente électroconductrice est constituée par une couche d'un oxyde semi-conducteur dopé ou métallique, déposée par pulvérisation cathodique sous vide, notamment à magnétron, ou par pyrolyse en phase liquide ou gazeuse si le substrat est thermiquement résistant (verre minéral) ou par une autre technique de dépôt (trempage, pulvérisation, sol-gel, ...), sur une épaisseur comprise entre 100 nm et 1000 nm, ayant une résistivité de surface de 2 à 40 Ω/□, en particulier de 15 à 30 Ω/□, une couche d'oxyde semi-conducteur dopé étant :
(a) ou bien disposée pour recouvrir au moins une face, de préférence une face tournée vers l'intérieur du vitrage multiple, d'une dalle composant ce dernier ;
(b) ou bien incluse au sein d'une dalle de substrat ;
(c) ou encore déposée sur au moins une face d'un film mince, transparent, de type poly(téréphtalate d'éthylène) (PET), ou d'une plaque de verre mince, ledit film ou ladite plaque constituant une couche supplémentaire dans la partie vitrée.

L'oxyde semi-conducteur dopé composant ces couches minces électroconductrices transparentes est notamment de l'oxyde d'indium dopé à l'étain (ITO) ou de l'oxyde d'étain dopé à l'antimoine ou au fluor. L'ITO est particulièrement préféré.

Comme indiqué ci-dessus au point (a), les couches minces électroconductrices transparentes sont, de préférence, déposées sur les faces des dalles de substrat qui sont tournées vers l'intérieur du vitrage multiple isolant. On peut ainsi mentionner comme particulièrement préférés les double vitrages dont au moins une face interne est recouverte par une couche d'oxyde semi-conducteur dopé.

Pour réaliser la variante (b), suivant laquelle une couche mince électroconductrice est incluse au sein d'une dalle de substrat, on peut déposer une telle couche mince sur au moins une face d'un film (F) transparent de PET, et utiliser ce film (F) dans la constitution d'un verre feuilleté de type PMMA/PVB ou PU/(F)/PVB ou PU/PMMA.

Dans le cas de la variante (c), on peut prévoir que le film mince - ou la plaque de verre mince - soit revêtu sur l'une de ses faces par la couche d'oxyde semi-conducteur et soit appliqué par exemple par collage, sur une face d'une dalle composant le vitrage multiple. On peut également prévoir qu'un tel film - ou une telle plaque - revêtu sur au moins l'une de ses faces soit tendu parallèlement aux dalles, dans un espace de gaz intermédiaire, des moyens étant prévus pour maintenir ledit film - ou ladite plaque - à sa périphérie dans le joint ; ce dernier peut ainsi comporter une gorge de retenue supplémentaire pour ledit film ou ladite plaque. Ledit film tendu peut également être appliqué contre une dalle et introduit avec cette dernière dans la gorge correspondante du joint.

Le film mince de type PET que l'on peut utiliser dans les variantes (b) ou (c) a notamment une épaisseur de l'ordre de 25 à 150 microns, notamment de 50 à 125 microns. Quant à la plaque de verre mince utilisable dans la variante (c), elle peut avoir une épaisseur de l'ordre de 0,5 à 2 mm, notamment de 0,5 mm à 1 mm.

Conformément à un second mode de réalisation de la présente invention, au moins une couche mince transparente électroconductrice est constituée par au moins une couche métallique M insérée entre deux couches d'un matériau transparent diélectrique D d'indice optique élevé, de façon à constituer un empilement de type DMD ou un empilement formé d'une association de plusieurs empilements de base, par exemple DMDMD, ledit empilement étant disposé pour recouvrir une face, de préférence une face tournée vers l'intérieur du vitrage, d'une dalle composant ce dernier.

En particulier, la couche métallique M est une couche d'or ou d'argent, et le matériau transparent diélectrique D d'indice optique élevé est le dioxyde d'étain ou le sulfure de zinc.

Les différentes couches constituant ces empilements sont, de façon bien connues, déposées par évaporation ou pulvérisation cathodique sous vide. Elles présentent chacune une épaisseur de l'ordre de 50 à 500 nanomètres (10⁻⁹ m).

D'une manière générale, on peut mentionner, comme particulièrement préférés, les double vitrages dont au moins une des faces, de préférence internes, est revêtue par un empilement DMD ou DMDMD tel qu'on vient de le définir.

Comme déjà évoqué, les couches peuvent être sur une face externe du vitrage et en particulier sur la face intérieure à l'avion notamment lorsqu'un "hublot décor" existe.

Egalement, lorsque l'une des dalles constituant le vitrage multiple du hublot est un feuilleté, les couches peuvent se trouver au sein de ladite dalle, appliquées sur l'une des faces internes d'un des constituants du feuilleté : sur l'une des feuilles de verre et/ou encore sur un film, notamment PET, intégré dans le feuilleté.

Conformément à la présente invention, le joint d'étanchéité dans lequel est montée la partie vitrée proprement dite du vitrage multiple isolant est constitué par un élastomère consistant avantageusement en un silicone ou fluorosilicone qui a été au moins en partie rendu conducteur par l'incorporation dans sa masse d'une charge conductrice de l'électricité, formée de granules ou fibres métalliques notamment d'argent, cuivre, aluminium, nickel, argent/cuivre, argent/aluminium, argent/verre, etc. ou de noir de carbone, ledit élastomère conducteur ayant notamment une résistivité volumique de 2 x 10⁻⁵ à 10⁻³ ohm·m (0,002 à 0,1 ohm·cm), la ou les couches minces électroconductrices étant en contact avec une partie conductrice du joint, laquelle est également destinée à venir en contact avec la structure dont on veut réaliser le blindage électromagnétique.

Il va de soi que l'élastomère de base constituant le joint comporte l'ensemble des propriétés requises pour l'application considérée : dureté Shore A, résistance à l'arrachement, déformation rémanente à la compression, allongement à la rupture, etc. et que l'incorporation de la charge conductrice n'aura pas modifié ces propriétés de façon substantielle. En particulier, la dureté Shore A du joint est avantageusement de 30 à 80.

Conformément à une première variante de réalisation, particulièrement intéressante, le joint est constitué de l'élastomère rendu conducteur dans toute sa masse.

Conformément à une autre variante, le joint est réalisé par comoulage de deux élastomères, dont l'un est l'élastomère conducteur de l'invention et est disposé pour coopérer avec la ou les couches minces électroconductrices de l'invention. On prévoira avantageusement que la partie conductrice du joint soit la partie interne, qu'il est plus aisé d'amener à coopérer avec la structure d'ensemble que l'on souhaite doter du blindage électromagnétique.

Par ailleurs, si la conduction du joint s'avère insuffisante, on peut prévoir, conformément à la présente invention, de doter ce dernier d'un renfort de conductivité, notamment constitué par :
- un film conducteur, par exemple de Cu étamé, ou un treillis métallique, ou une peinture conductrice, par exemple une laque d'Ag, appliqué sur au moins une partie de la surface du joint ; et/ou
- un feuillard métallique ou clinquant métallique ou un treillis métallique ou un ruban métallique adhésif placé à la périphérie du vitrage ou en des points ou des régions de ladite périphérie, contre au moins une partie interne du joint, de façon à venir en contact avec une couche mince électromagnétique et/ou avec la structure dont on veut réaliser le blindage électromagnétique : et/ou
- un émail conducteur ou une pâte conductrice déposé sur une couche mince conductrice et venant en contact avec le joint ou le cas échéant avec un feuillard ou clinquant ou ruban métallique, à la périphérie du vitrage ou en des points ou régions de ladite périphérie.

De façon particulièrement préférée, le vitrage multiple isolant de La présente invention consiste en un hublot d'avion comportant un blindage électromagnétique à au moins 10 db, en particulier 10 db à 30 db.

Pour mieux illustrer l'objet de la présente invention, on va en décrire ci-après, à titre indicatif et non limitatif, plusieurs modes de réalisation en référence au dessin annexé.

Sur ce dessin :
- la Figure 1 est une vue en élévation extérieure d'un hublot ; et
- les Figures 2 à 4 représentent chacune, à plus grande échelle, une vue en perspective et en coupe selon II-II de la Figure 1, conforme à un mode particulier du blindage électromagnétique.

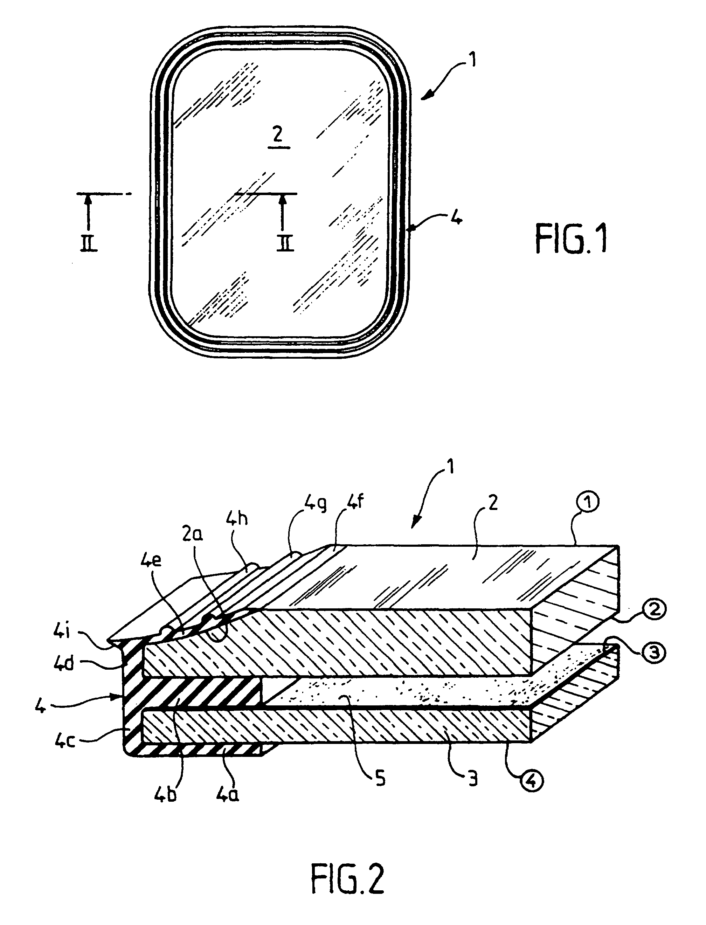

Si l'on se réfère aux Figures 1 et 2, on peut voir que l'on a désigné par 1 dans son ensemble un hublot d'avion ayant la forme générale d'un rectangle aux angles arrondis.

Le hublot 1 comporte de façon traditionnelle deux dalles (2, 3) de poly(méthacrylate de méthyle) étiré, qui sont disposées en regard et à distance l'une de l'autre, et qui sont maintenues par un joint d'étanchéité périphérique 4 en élastomère, par lequel le hublot est destiné à venir s'encastrer dans le fuselage métallique de l'avion.

La dalle extérieure 2 a la forme d'une plaque relativement épaisse, dont la bordure périphérique 2a est biseautée. La dalle intérieure 3 consiste en une plaque moins épaisse que la dalle 2. Par ailleurs, de façon classique, les deux dalles 2 et 3 sont bombées, de concavité tournée vers l'intérieur.

Un hublot de ce type est celui commercialisé pour l'avion A320. Il a la forme d'un rectangle de 380 mm de hauteur et 280 mm de largeur, avec un rayon de courbure aux angles d'environ 3000 mm. L'épaisseur de la dalle extérieure 2 est de 9 mm et celle de la dalle intérieure, de 4 mm. La lame d'air 5 qui sépare les deux dalles 2 et 3 a une épaisseur de 5 mm.

Le joint périphérique 4 présente un profil ayant la forme générate d'un U comportant deux ailes 4a et 4b parallèles entre elles et raccordées à un fond 4c, les ailes 4a et 4b et le fond c délimitant intérieurement une gorge périphérique dans laquelle est reçue de manière étanche la bordure de la dalle intérieure 3. Par ailleurs, le fond 4c présente un prolongement 4d du côté de l'aile 4b, puis est replié pour former une aile extérieure 4e, située en regard de l'aile centre 4b, mais inclinée vers l'extérieur. Les ailes 4b et 4e délimitent, avec le prolongement 4d, une seconde gorge destinée à recevoir de manière étanche la bordure périphérique de la dalle extérieure 2, l'aile inclinée 4e venant s'appliquer contre la bordure extérieure biseautée 2a de la dalle 2.

L'aile centrale 4b présente une épaisseur correspondant à l'écartement voulu entre les dalles 2 et 3.

L'aile extérieure 4e présente une bordure libre 4f biseautée de façon à se situer, en position de montage, dans le prolongement de la face externe de la dalle 2. Par ailleurs, elle présente extérieurement deux bourrelets périphériques 4g et 4h et se prolonge, à l'opposé du fond 4d, par un rebord 4i, les bourrelets 4g et 4h et le rebord 4i ayant pour rôle d'assurer l'étanchéité à l'air.

De façon traditionnelle; les différentes faces du double vitrage ainsi constitué sont numérotées ① à ④ en allant de l'extérieur vers l'intérieur de l'avion. Egalement, la dalle 3 comporte, au voisinage du joint 4, un petit orifice (non représenté), de telle sorte que la pressurisation de l'avion s'applique sur la dalle externe 2.

Le hublot 1 qui vient d'être décrit présente la particularité de comporter un blindage électromagnétique destiné à assurer la continuité du blindage électromagnétique du fuselage de l'avion. Ce blindage électromagnétique est obtenu, d'une part, par une couche mince électroconductrice transparente 5 d'ITO, déposée sur la totalité de la face ? sous une épaisseur de l'ordre de 400 nm et ayant une conductivité de surface de 15 Ω/□, et d'autre part par le fait que le joint 4 est choisi en un élastomère conducteur répondant aux caractéristiques indiquées ci-dessus dans le préambule de la présente description. La couche 5 et le joint 4 sont en contact sur toute la périphérie, par l'une des faces latérales de l'aile 4b.

Bien que l'on puisse indifféremment déposer la couche 4 sur n'importe quelle face ① à ④, on préfère la déposer sur une face interne, et de préférence encore sur la face ③, car la dalle 3 est de forme plus simple et moins délicate à fabriquer que la dalle 2, et il est plus aisé de prévoir le raccordement à la structure de l'avion pour réaliser le blindage électromagnétique.

Par ailleurs, on aurait pu réaliser le joint en deux parties, séparées par exemple suivant le plan moyen de l'aile centrale 4b, la partie externe étant en élastomère non conducteur, seule la partie interne, coopérant avec la couche 5, ayant été rendue conductrice.

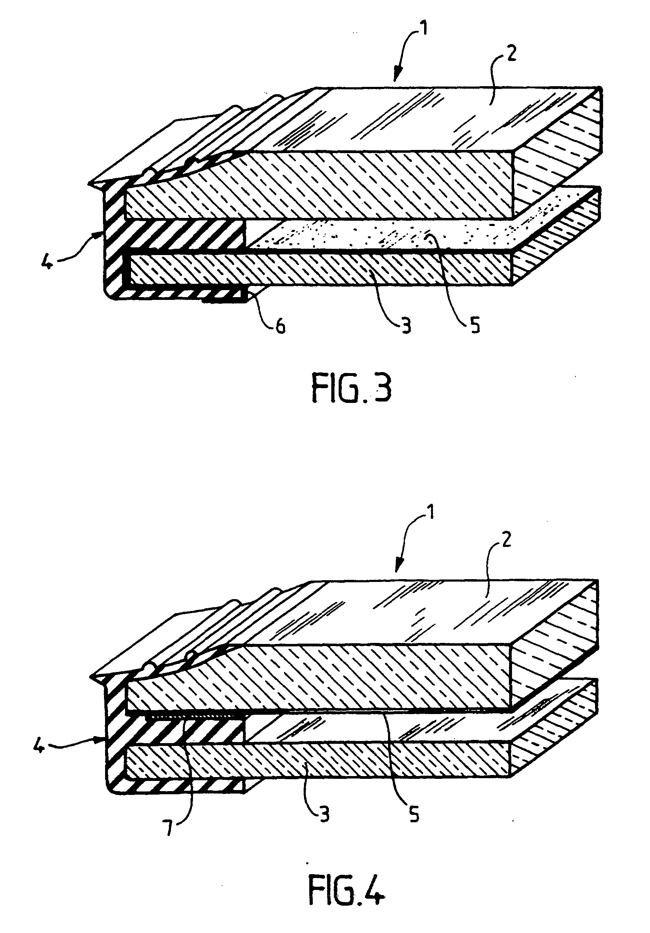

Si l'on se réfère maintenant à la Figure 3, on peut voir que l'on a représenté une variante de hublot identique à celle de la Figure 2 (les mêmes chiffres de référence ayant été repris pour désigner les mêmes éléments), à ceci près que l'on a prévu de renforcer la conduction par l'interposition de plusieurs clinquants métalliques 6, par exemple en cuivre étamé, disposés entre l'aile 4a du joint 4 et la dalle 3 et se prolongeant, d'un côté, pour entourer la bordure de la dalle 3, et de l'autre côté, pour entourer la bordure libre de l'aile 4a. Les clinquants métalliques 6, au nombre de 8 par exemple, sont régulièrement répartis à la périphérie de la dalle 3.

Ces clinquants métalliques 6 peuvent être remplacés par des rubans métalliques, par exemple de cuivre, d'aluminium, ou de cuivre étamé, doublé par un adhésif sensible à la pression, hautement conducteur, appliqué contre la dalle 3, ledit adhésif contenant une dispersion de particules conductrices résistantes à l'oxydation, qui créent une très faible résistance électrique à travers le ruban.

La variante représentée sur la Figure 4 diffère des précédentes par le fait que la couche mince électroconductrice 5 d'ITO est appliquée contre la dalle 2 et que la conduction entre la couche mince 5 et le joint 4 est renforcée ici par le dépôt, au voisinage de la périphérie de la dalle 2, sur la couche 5, d'une pâte d'argent 7 qui, dans la position montée de la partie vitrée dans le joint 4, se situe contre la face en regard de l'aile centrale 4b, par exemple à partir de sa bordure jusqu'au voisinage du fond 4c. Cette pâte d'argent 7 est par exemple composée de résine organique chargée à l'argent et est appliquée sur la couche mince 5 par une technique de sérigraphie.

Dans le cas où la dalle 2 aurait été réalisée en verre, la pâte d'argent 7 serait remplacée par un émail à base d'argent, composé par exemple de fritte de verre chargée à l'argent et appliquée par une technique de sérigraphie.

Il est bien entendu que les modes de réalisation qui viennent d'être décrits ont été donnés à titre indicatif et non limitatif et que des modifications peuvent être apportées sans que l'on s'écarte pour autant du cadre de la présente invention.

## Revendications

1. Vitrage multiple isolant dont la partie vitrée comporte au moins deux dalles superposées (2 ; 3) de substrat transparent, mécaniquement résistant, au moins une couche mince transparente électro-conductrice continue (5), avec interposition d'au moins une lame de gaz, lesdites dalles (2; 3) étant montées, à leur périphérie, dans un joint d'étanchéité (4) par lequel ledit vitrage (1) est apte à venir s'encastrer dans une structure qui est destinée à enfermer un espace contenant des équipements susceptibles d'être perturbés par un champ électro-magnétique et qui a une fonction de blindage électro-magnétique, **caractérisé en ce que** le joint (4) est au moins en partie rendu conducteur pour assurer un raccordement de ladite ou desdites couches minces transparentes électro-conductrices (5) à ladite structure, les conductivités de ladite ou desdites couches minces transparentes électro-conductrices (5) et dudit joint (4) étant choisies pour assurer la continuité du blindage électromagnétique de ladite structure, **en ce que** ledit joint est formé d'une première (4a) et seconde ailes (4b) parallèles et raccordées à un fond (4c) délimitant une première gorge dans laquelle est reçue de manière étanche la dalle intérieure et **en ce que** le fond (4c) présente un prolongement (4d) du côté de la seconde aile (4b), ledit prolongement formant en outre une aile extérieure (4e) située en regard de la seconde aile (4b), les deux ailes (4b, 4e) délimitant, avec le prolongement (4d), une seconde gorge destinée à recevoir de manière étanche la bordure périphérique de la dalle extérieure (2).

2. Vitrage selon la revendication 1, **caractérisé par le fait que** les dalles (2 ; 3) de substrat transparent, mécaniquement résistant, sont constituées par des plaques de verre monolithique, ou par des plaques de polymère, ou par des plaques de verre feuilleté.

3. Vitrage selon l'une des revendications 1 et 2, **caractérisé par le fait que** la ou les couches minces électroconductrices (5) sont disposées à l'intérieur de celui-ci.

4. Vitrage selon l'une des revendications 1 à 3, **caractérisé par le fait qu'**au moins une couche mince transparente électroconductrice (5) est constituée par une couche d'un oxyde semi-conducteur dopé, déposée notamment par pulvérisation cathodique sous vide ou par pyrolyse en phase liquide ou gazeuse, sur une épaisseur comprise entre 100 nm et 1000 nm, ayant une résistivité de surface de 2 à 40 Ω/□, en particulier de 15 à 30 Ω/□, une couche d'oxyde semi-conducteur dopé ou bien étant disposée pour recouvrir au moins une face, de préférence une face tournée vers l'intérieur du vitrage, d'une dalle composant ce dernier, ou bien étant incluse au sein d'une dalle, ou encore étant déposée sur au moins une face d'un film mince transparent de type poly(téréphtalate d'éthylène), ou d'une plaque de verre mince, intégré comme couche supplémentaire dans la partie vitrée.

5. Vitrage selon la revendication 4, **caractérisé par le fait que** l'oxyde semi-conducteur est de l'oxyde d'indium dopé à l'étain (ITO) ou de l'oxyde d'étain dopé à l'antimoine ou au fluor.

6. Vitrage selon l'une des revendications 1 à 3, **caractérisé par le fait qu'**au moins une couche mince transparente électroconductrice (5) est constituée par au moins une couche métallique M insérée entre deux couches d'un matériau transparent diélectrique D d'indice optique élevé, de façon à constituer un empilement de type DMD ou des associations de plusieurs empilements de base du type DMDMD, ledit ou lesdits empilements étant disposés pour recouvrir une face, de préférence une face tournée vers l'intérieur du vitrage, d'une dalle composant ce dernier, ou encore, lorsque l'une des dalles constituant le vitrage multiple du hublot est un feuilleté, au sein de ladite dalle, appliqués sur l'une des faces internes d'un des constituants du feuilleté : sur l'une des feuilles de verre et/ou sur un film intégré dans le feuilleté.

7. Vitrage selon la revendication 6, **caractérisé par le fait que** la couche métallique M est une couche d'or ou d'argent, et que le matériau transparent diélectrique D d'indice optique élevé est le dioxyde d'étain ou le sulfure de zinc.

8. Vitrage selon l'une des revendications 1 à 7, **caractérisé par le fait que** le joint (4) est constitué par un élastomère consistant en un silicone ou fluorosilicone qui a été au moins en partie rendu conducteur par l'incorporation dans sa masse d'une charge conductrice de l'électricité, formée de grandes ou fibres métalliques notamment d'argent, cuivre, aluminium, nickel, argent/cuivre, argent/aluminium, argent/verre, ou de noir de carbone, ledit élastomère conducteur ayant notamment une résistivité volumique de 2 x 10⁻⁵ à 10⁻³ ohm·m (0,002 à 0,1 ohm·cm), la ou les couches minces électroconductrices (5) étant en contact avec une partie conductrice du joint (4), laquelle est également destinée à venir en contact avec la structure dont on veut réaliser le blindage électromagnétique.

9. Vitrage selon la revendication 8, **caractérisé par le fait que** l'élastomère présente une dureté Shore A de 30 à 80.

10. Vitrage selon l'une des revendications 8 et 9, **caractérisé par le fait que** le joint est constitué de l'élastomère rendu conducteur dans toute sa masse.

11. Vitrage selon l'une des revendications 8 et 9, **caractérisé par le fait que** le joint (4) est réalisé par comoulage de deux élastomères, dont l'un a été rendu conducteur et est disposé pour coopérer avec la ou les couches minces électroconductrices (5).

12. Vitrage selon l'une des revendications 8 à 11, **caractérisé par le fait qu'**il est doté d'un renfort de conductivité constitué par :
- un film conducteur ou une couche conductrice ou une peinture conductrice sur au moins une partie de la surface du joint ; et/ou
- un feuillard métallique ou clinquant métallique (6) ou un ruban métallique adhésif placé à la périphérie du vitrage ou en des points ou des régions de ladite périphérie, contre au moins une partie interne du joint, de façon à venir en contact avec une couche mince électromagnétique (5) et/ou avec la structure dont on veut réaliser le blindage électromagnétique ; et/ou
- un émail conducteur (7) ou une pâte conductrice déposé sur une couche mince conductrice et venant en contact avec le joint ou le cas échéant avec un feuillard ou clinquant ou ruban métallique, à la périphérie du vitrage ou en des points ou régions de ladite périphérie.

13. Vitrage selon l'une des revendications 1 à 12, **caractérisé par le fait qu'**il consiste en un hublot d'avion comportant un blindage électromagnétique à au moins 10 db, en particulier 10 db à 30 db.

## Patentansprüche

1. Mehrfachisolierverglasung, deren Glasteil mindestens zwei übereinander angeordnete Scheiben (2; 3) aus einem mechanisch widerstandsfähigen, transparenten Substrat und mindestens eine ununterbrochene, elektrisch leitfähige, transparente dünne Schicht mit dazwischen mindestens einer Gasfüllung umfasst, wobei die Scheiben (2; 3) an ihrem Umfang in einer Dichtung (4) angebracht sind, durch welche die Verglasung (1) in der Lage ist, in eine Struktur eingebaut zu werden, die vorgesehen ist, einen Raum abzuschließen, der Ausrüstungen enthält, die von einem Elektromagnetfeld gestört werden können, und welche eine elektromagnetische Abschirmungsfunktion besitzt, **dadurch gekennzeichnet, dass** die Dichtung (4) wenigstens teilweise leitfähig gemacht worden ist, um eine Verbindung der elektrisch leitfähigen, transparenten dünnen Schicht/en (5) mit der Struktur sicherzustellen, wobei die Leitfähigkeiten der elektrisch leitfähigen, transparenten dünnen Schicht/en (5) und der Dichtung (4) ausgewählt sind, um die Kontinuität der elektromagnetischen Abschirmung dieser Struktur sicherzustellen, **dass** die Dichtung von einem ersten (4a) und einem zweiten Schenkel (4b) gebildet wird, die parallel verlaufen und mit einem Boden (4c) verbunden sind, der eine erste Nut begrenzt, von welcher die innere Scheibe dicht aufgenommen wird, **und dass** der Boden (4c) auf der Seite des zweiten Schenkels (4b) eine Verlängerung (4d) aufweist, die außerdem einen Außenschenkel (4e) bildet, der sich gegenüber dem zweiten Schenkel (4b) befindet, und die zwei Schenkel (4b, 4e) mit der Verlängerung (4d) eine zweite Nut bilden, die vorgesehen ist, den Rand der äußeren Scheibe (2) dicht aufzunehmen.

2. Verglasung nach Anspruch 1, **dadurch gekennzeichnet, dass** die Scheiben (2; 3) aus einem mechanisch widerstandsfähigen, transparenten Substrat aus monolithischen Glasscheiben, aus Polymer- oder Verbundglasscheiben bestehen.

3. Verglasung nach Anspruch 1 oder 2, **dadurch gekennzeichnet, dass** die elektrisch leitfähige/n dünne/n Schicht/en (5) im Inneren von ihr angeordnet ist/sind.

4. Verglasung nach einem der Ansprüche 1 bis 3, **dadurch gekennzeichnet, dass** mindestens eine elektrisch leitfähige, transparente dünne Schicht (5) aus einer Schicht aus einem dotierten halbleitenden Oxid besteht, die insbesondere durch Kathodenzerstäubung im Vakuum, Pyrolyse aus der Flüssigphase oder Gasphasenabscheidung mit einer Dicke von 100 bis 1000 nm und einem Flächenwiderstand von 2 bis 40 Ω/□, insbesondere 15 bis 30 Ω/□, aufgebracht worden ist, wobei eine Schicht aus einem dotierten halbleitenden Oxid angeordnet ist, um wenigstens eine Seite und vorzugsweise eine zum Inneren der Verglasung zeigende Seite einer diese bildenden Scheibe zu bedecken oder in einer Scheibe eingeschlossen zu sein, oder auch auf mindestens einer Seite einer transparenten dünnen Folie vom Typ Polyethylenterephthalat oder einer Scheibe aus dünnem Glas, die als Ergänzungsschicht im Glasteil integriert ist, aufgebracht ist.

5. Verglasung nach Anspruch 4, **dadurch gekennzeichnet, dass** das halbleitende Oxid mit Zinn dotiertes Indiumoxid (ITO) oder mit Antimon bzw. Fluor dotiertes Zinnoxid ist.

6. Verglasung nach einem der Ansprüche 1 bis 3, **dadurch gekennzeichnet, dass** mindestens eine elektrisch leitfähige, transparente dünne Schicht (5) aus mindestens einer Metallschicht M besteht, die zwischen zwei Schichten aus einem dielektrischen transparenten Material D mit hohem Brechungsindex derart eingefügt ist, dass ein Aufbau vom Typ DMD gebildet wird, oder Aggregate aus mehreren Grundaufbauten vom Typ DMDMD gebildet werden, wobei der/die Aufbau/ten angeordnet wird/werden, um eine Seite, vorzugsweise eine zum Inneren der Verglasung zeigende Seite einer diese bildenden Scheibe zu bedecken, oder auch, wenn eine der die Mehrfachverglasung des Kabinenfensters bildenden Scheiben eine Verbundglasscheibe ist, in dieser Scheibe angeordnet wird/werden, auf einer der Innenseiten eines der Bestandteile der Verbundglasscheibe: auf einer der Glasscheiben und/oder einer im Verbund integrierten Folie aufgebracht.

7. Verglasung nach Anspruch 6, **dadurch gekennzeichnet, dass** die Metallschicht M eine Gold- oder Silberschicht ist, und dass das dielektrische transparente Material D mit hohem Brechungsindex Zinndioxid oder Zinksulfid ist.

8. Verglasung nach einem der Ansprüche 1 bis 7, **dadurch gekennzeichnet, dass** die Dichtung (4) aus einem Elastomer besteht, das aus einem Silicon oder Fluorsilicon besteht, das durch den Einbau einer elektrisch leitfähigen Füllung wenigstens teilweise elektrisch leitfähig gemacht worden ist, die aus Körnchen oder Fasern aus einem Metall, insbesondere Silber, Kupfer, Aluminium, Nickel, Silber/Kupfer, Silber/Aluminium und Silber/Glas, oder Ruß besteht, wobei das leitfähige Elastomer insbesondere einen spezifischen elektrischen Volumenwiderstand von 2·10⁻⁵ bis 10⁻³ Ohm·m (0,002 bis 0,1 Ohm·cm) besitzt und die elektrisch leitfähige/n dünne/n Schicht/en (5) sich in Kontakt mit einem leitfähigen Teil der Dichtung (4) befindet/befinden, die auch vorgesehen ist, mit der Struktur in Berührung zu kommen, aus welcher die elektromagnetische Abschirmung realisiert werden soll.

9. Verglasung nach Anspruch 8, **dadurch gekennzeichnet, dass** die Shore-Härte A des Elastomers 30 bis 80 beträgt.

10. Verglasung nach Anspruch 8 oder 9, **dadurch gekennzeichnet, dass** die Dichtung aus dem Elastomer besteht, das in seiner gesamten Masse leitfähig gemacht worden ist.

11. Verglasung nach Anspruch 8 oder 9, **dadurch gekennzeichnet, dass** die Dichtung (4) durch Coformgebung von zwei Elastomeren hergestellt worden ist, wovon eines leitfähig gemacht und angeordnet worden ist, um mit der/den elektrisch leitfähigen dünnen Schicht/en (5) zusammenzuwirken.

12. Verglasung nach einem der Ansprüche 8 bis 11, **dadurch gekennzeichnet, dass** sie mit einer Leitfähigkeitsverstärkung versehen ist, die besteht aus:
- einer leitfähigen Folie, einer leitfähigen Schicht oder einer leitfähigen Lackierung auf wenigstens einem Teil der Oberfläche der Dichtung und/oder
- einem Metallblech bzw. einer Metallfolie (6) oder einem haftfähigen Metallband, das/die am Umfang der Verglasung oder an Punkten oder Bereichen dieses Umfangs gegen mindestens einen Innenteil der Dichtung derart angeordnet ist, dass es/sie mit einer elektromagnetischen dünnen Schicht (5) und/oder mit der Struktur, für welche die elektromagnetische Abschirmung realisiert werden soll, in Berührung kommt, und/oder
- einem leitfähigen Email (7) oder einer leitfähigen Paste, das/die auf einer leitfähigen dünnen Schicht aufgebracht ist und mit der Dichtung oder gegebenenfalls mit einem Metallblech, einer -folie oder einem -band am Umfang der Verglasung oder an Punkten bzw. Bereichen dieses Umfangs in Berührung kommt.

13. Verglasung nach einem der Ansprüche 1 bis 12, **dadurch gekennzeichnet, dass** sie ein Flugzeugfenster bildet, das eine elektromagnetische Abschirmung um mindestens 10 dB und insbesondere 10 bis 30 dB umfasst.

## Claims

1. Isolating multiple glazing unit, the glazed part of which comprises at least two superposed, mechanically resistant, transparent substrate panes (2; 3), at least one thin continuous electrically conductive transparent layer (5), with interposition of at least one gas layer, the said panes (2; 3) being mounted, around their periphery, in a seal (4) via which the said glazing (1) can be fitted into a structure that is intended to enclose a space containing equipment liable to suffer interference by an electromagnetic wave and which provides an electromagnetic screening function, **characterized in that** the seal (4) is at least made partly conductive in order to connect the said thin electrically conductive transparent layer or layers (5) to the said structure, the conductivity of the said thin electrically conductive transparent layer or layers (5) and the conductivity of the said seal (4) both being chosen to ensure continuity of the electromagnetic screening of the said structure, **in that** the said seal is formed from a first flange (4a) and a second flange (4b) that are parallel and connected to a base (4c) defining a first groove in which the inner pane is housed in a sealed manner and **in that** the base (4c) has an extension (4d) on the same side as the second flange (4b), the said extension furthermore forming an outer flange (4e) located opposite the second flange (4b), the two flanges (4b, 4e) defining, with the extension (4d), a second groove intended to house the peripheral edge of the outer pane (2) in a sealed manner.

2. Glazing unit according to Claim 1, **characterized in that** the transparent, mechanically resistant, substrate panes (2; 3) are formed by sheets of monolithic glass, or by sheets of polymer, or by sheets of laminated glass.

3. Glazing unit according to either of Claims 1 and 2, **characterized in that** the thin electrically conductive layer or layers (5) is (are) placed on the inside of the latter.

4. Glazing unit according to one of Claims 1 to 3, **characterized in that** at least one transparent thin electrically conductive layer (5) is formed by a layer of a doped semiconducting oxide deposited by vacuum sputtering, especially or by liquid-phase or gas-phase pyrolysis, with a thickness of between 100 nm and 1000 nm, having a surface resistivity of 2 to 40 Ω/□, in particular from 15 to 30 Ω/□, a layer of doped semiconducting oxide either being placed so as to cover at least one face, preferably a face turned towards the interior of the glazing unit, of a constituent pane of the latter, or being included within a pane, or else being deposited on at least one face of a thin transparent film of the polyethylene terephthalate type, or of a thin glass sheet, which is integrated as an additional layer into the glazed part.

5. Glazing unit according to Claim 4, **characterized in that** the semiconducting oxide is tin-doped indium oxide (ITO) or antimony-doped or fluorine-doped tin oxide.

6. Glazing unit according one of Claims 1 to 3, **characterized in that** at least one thin electrically conductive transparent layer (5) is formed by at least one layer of metal M inserted between two layers of a transparent dielectric D of high optical index, so as to constitute a multilayer of the DMD type or combinations of several base multilayers of the DMDMD type, the said multilayer or multilayers being placed so as to cover one face, preferably a face turned towards the interior of the glazing unit, of a constituent pane of the latter, or else, when one of the constituent panes of the multiple glazing unit of the window is a laminated pane, the layers may be within the said pane and applied to one of the internal faces of one of the constituents of the laminated pane, on one of the sheets of glass and/or on a film incorporated into the laminated pane.

7. Glazing unit according to Claim 6, **characterized in that** the layer of metal M is a layer of gold or silver and **in that** the transparent dielectric D of high optical index is tin dioxide or zinc sulphide.

8. Glazing unit according to one of Claims 1 to 7, **characterized in that** the seal (4) is made of an elastomer consisting advantageously of a silicone or fluorosilicone that has been made at least partly conductive by incorporating, throughout its volume, an electrically conductive filler formed from metal granules or fibres, especially those made of silver, copper, aluminium, nickel, silver/copper, silver/aluminium, silver/glass, or carbon black, the said conductive elastomer having in particular a volume resistivity of 2 × 10⁻⁵ to 10⁻³ ohm·m (0.002 to 0.1 ohm·cm), the thin electrically conductive layer or layers (5) being in contact with a conductive part of the seal (4), which conductive part is also intended to come into contact with the structure that it is desired to electromagnetically screen.

9. Glazing unit according to Claim 8, **characterized in that** the elastomer has a Shore A hardness of 30 to 80.

10. Glazing unit according to either of Claims 8 and 9, **characterized in that** the seal is made of the elastomer made conductive throughout its volume.

11. Glazing unit according to either of Claims 8 and 9, **characterized in that** the seal (4) is produced by comoulding two elastomers, one of which has been made conductive and is placed so as to cooperate with the thin electrically conductive layer or layers (5).

12. Glazing unit according to one of Claims 8 to 11, **characterized in that** it is provided with a conductivity enhancement formed by:
- a conductive film or a conductive layer or a conductive paint applied to at least one part of the surface of the seal; and/or
- a metal foil or metal shim (6) or a metal strip which is adhesive and placed around the periphery of the glazing unit, or at points or regions of the said periphery, against at least one internal part of the seal, so as to come into contact with a thin electromagnetic layer (5) and/or with the structure that it is desired to electromagnetically screen; and/or
- a conductive enamel (7) or a conductive paste deposited on a thin conductive layer and coming into contact with the seal or, as the case may be, with a metal foil or shim or strip, around the periphery of the glazing unit or at points or regions of the said periphery.

13. Glazing unit according to one of Claims 1 to 12, **characterized in that** it consists of an aircraft window that provides electromagnetic screening to at least 10 dB, in particular 10 dB to 30 dB.
